(19) Europäisches Patentamt / European Patent Office / Office européen des brevets

(11) **EP 4 333 567 A1**

(12) **EUROPEAN PATENT APPLICATION**
published in accordance with Art. 153(4) EPC

(43) Date of publication:
**06.03.2024  Bulletin 2024/10**

(21) Application number: **22807389.6**

(22) Date of filing: **28.04.2022**

(51) International Patent Classification (IPC):
**H05K 3/44** (2006.01)          **B32B 15/04** (2006.01)
**B32B 15/08** (2006.01)          **H05K 1/03** (2006.01)
**H05K 1/05** (2006.01)

(52) Cooperative Patent Classification (CPC):
**B32B 15/04; B32B 15/08; H05K 1/03; H05K 1/05; H05K 3/44**

(86) International application number:
**PCT/JP2022/019428**

(87) International publication number:
**WO 2022/239687 (17.11.2022 Gazette 2022/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.05.2021  JP 2021079608**

(71) Applicant: **Denka Company Limited
Tokyo 103-8338 (JP)**

(72) Inventors:
• **GONDA, Yuhei
  Tokyo 103-8338 (JP)**
• **KUMAGAI, Ryota
  Tokyo 103-8338 (JP)**

(74) Representative: **Mewburn Ellis LLP
Aurora Building
Counterslip
Bristol BS1 6BX (GB)**

(54) **MULTILAYER BODY, CIRCUIT BOARD AND METHOD FOR PRODUCING CIRCUIT BOARD**

(57)    A multilayer body including a first metal layer, an insulation layer disposed on the first metal layer, and a second metal layer disposed on the insulation layer, in which at least one of a bonding surface of the first metal layer in contact with the insulation layer and a bonding surface of the second metal layer in contact with the insulation layer shows a surface roughness curve having a reference length of 250 $\mu$m, an average length of elements RSm of 10 $\mu$m or more and 100 $\mu$m or less, and a maximum height Rz of 1 $\mu$m or more and 20 $\mu$m or less.

*Fig.1*

EP 4 333 567 A1

## Description

## Technical Field

The present disclosure relates to a multilayer body suitably used for the production of a circuit board (metal base circuit board), a circuit board, and a method for producing a circuit board.

## Background Art

As circuit boards for mounting electronic and electrical components, including semiconductor elements, to form hybrid integrated circuits, various circuit boards have been hitherto put into practical use. Circuit boards are classified into resin circuit boards, ceramic circuit boards, metal base circuit boards, and the like, based on the substrate material.

Although resin circuit boards are inexpensive, since the substrates have low thermal conductivity, their use is limited to use applications in which circuit boards are utilized with relatively small amounts of electric power. Ceramic circuit boards are suitable for use applications in which circuit boards are utilized with relatively large amounts of electric power, due to the characteristics of ceramics exhibiting high electrical insulation properties and high heat resistance; however, ceramic circuit boards have a disadvantage of being highly expensive. On the other hand, metal base circuit boards have properties intermediate between the two and are suitable for general-purpose use applications in which circuit boards are utilized with relatively large amounts of electric power, for example, refrigerator inverters, commercial air conditioning inverters, industrial robot power supplies, and automobile power supplies.

For example, Patent Literature 1 discloses a method for obtaining a circuit board having excellent stress relaxation properties, heat resistance, moisture resistance, and heat dissipation properties, by using a composition for a circuit board containing a specific epoxy resin, a curing agent, and an inorganic filler material as essential components.

## Citation List

## Patent Literature

Patent Literature 1: Japanese Unexamined Patent Publication No. 2008-266533

## Summary of Invention

## Technical Problem

When ceramic circuit boards can be replaced with metal base circuit boards, productivity can be expected to improve. In the fields of industrial modules and the like where ceramic circuit boards are used, high voltages may be applied under harsh conditions, and high reliability under such conditions is required.

In addition, ceramic circuit boards have a problem that solder cracks are likely to occur on the substrate during heat cycling; however, the occurrence of solder cracks can be expected to be suppressed by replacing ceramic circuit boards with metal base circuit boards. On the other hand, in the fields of industrial modules and the like where ceramic circuit boards are used, high-temperature treatments such as a solder reflow treatment are performed; however, in conventional metal base circuit boards, there are occasions in which the adhesion reliability of the insulation layer after a high-temperature treatment is lowered.

Thus, it is an object of the present invention to provide a multilayer body capable of forming a metal base circuit board which has excellent insulation reliability under the conditions of high voltage application and can maintain high adhesion reliability even after a high-temperature treatment. In addition, it is another object of the present invention to provide a metal base circuit board that has excellent insulation reliability under the conditions for high voltage application and can maintain high adhesion reliability even after a high-temperature treatment, and a method for producing the metal base circuit board.

## Solution to Problem

The present invention relates to, for example, the following [1] to [10].

[1] A multilayer body including:

a first metal layer;
an insulation layer disposed on the first metal layer; and

a second metal layer disposed on the insulation layer,

in which at least one of a bonding surface of the first metal layer in contact with the insulation layer and a bonding surface of the second metal layer in contact with the insulation layer shows a surface roughness curve having a reference length of 250 $\mu$m, an average length of elements RSm of 10 $\mu$m or more and 100 $\mu$m or less, and a maximum height Rz of 1 $\mu$m or more and 20 $\mu$m or less.

[2] The multilayer body according to [1], in which both the bonding surface of the first metal layer in contact with the insulation layer and the bonding surface of the second metal layer in contact with the insulation layer show the surface roughness curve.

[3] The multilayer body according to [1] or [2], in which the insulation layer has a thickness of 30 $\mu$m or more.

[4] The multilayer body according to any one of [1] to [3], in which the first metal layer and the second metal layer contain 60% by mass or more of at least one kind of metal atoms selected from the group consisting of aluminum, copper, iron, silver, gold, zinc, nickel, and tin.

[5] The multilayer body according to any one of [1] to [4], in which the insulation layer contains an insulating resin cured body and an inorganic filler material.

[6] The multilayer body according to any one of [1] to [5], in which the average length of elements RSm and the maximum height Rz satisfy the following Formula (A):

$$RSm \geq 1.25Rz + 12 \ldots (A).$$

[7] A circuit board including:

a metal layer;

an insulation layer disposed on the metal layer; and

a metal circuit part disposed on the insulation layer,

in which at least one of a bonding surface of the metal layer in contact with the insulation layer and a bonding surface of the metal circuit part in contact with the insulation layer shows a surface roughness curve having a reference length of 250 $\mu$m, an average length of elements RSm of 10 $\mu$m or more and 100 $\mu$m or less, and a maximum height Rz of 1 $\mu$m or more and 20 $\mu$m or less.

[8] The circuit board according to [7], in which both the bonding surface of the metal layer in contact with the insulation layer and the bonding surface of the metal circuit part in contact with the insulation layer show the surface roughness curve.

[9] The circuit board according to [7] or [8], in which the average length of elements RSm and the maximum height Rz satisfy the following Formula (A):

$$RSm \geq 1.25Rz + 12 \ldots (A).$$

[10] A method for producing a circuit board, the method including:

a step of preparing the multilayer body according to [1] to [6]; and

a step of removing a portion of the first metal layer or a portion of the second metal layer of the multilayer body to form a metal circuit part.

**Advantageous Effects of Invention**

According to the present invention, there is provided a multilayer body capable of forming a metal base circuit board that has excellent insulation reliability under the conditions of high voltage application and can maintain high adhesion reliability even after a high-temperature treatment. In addition, according to the present invention, there are provided a metal base circuit board that has excellent insulation reliability even under the conditions of high voltage application and can maintain high adhesion reliability even after a high-temperature treatment, and a method for producing the metal base circuit board.

**Brief Description of Drawings**

FIG. 1 is a cross-sectional view illustrating an embodiment of a multilayer body.

FIG. 2 is a cross-sectional view illustrating an embodiment of a circuit board.

FIG. 3 is a diagram showing the relationship between RSm and Rz in the circuit members of Examples and Comparative Examples.

**Description of Embodiments**

Suitable embodiments of the present invention will be described in detail below.

[Multilayer body]

A multilayer body of the present embodiment includes a first metal layer, an insulation layer disposed on the first metal layer, and a second metal layer disposed on the insulation layer. The multilayer body of the present embodiment may be referred to as a multilayer body for forming a circuit board.

In the multilayer body of the present embodiment, at least one of a bonding surface (S1) of the first metal layer in contact with the insulation layer, and a bonding surface (S2) of the second metal layer in contact with the insulation layer, shows a surface roughness curve having a reference length of 250 $\mu$m, an average length of elements RSm of 10 $\mu$m or more and 100 $\mu$m or less, and a maximum height Rz of 1 $\mu$m or more and 20 $\mu$m or less.

According to the multilayer body of the present embodiment, a metal base circuit board that has excellent insulation reliability (particularly, an effect of suppressing deterioration of electrical insulation properties over time) under the conditions of high voltage application and can maintain high adhesion reliability even after a high-temperature treatment, can be formed. The reason why an effect related to insulation reliability is provided by the multilayer body of the present embodiment is not necessarily clearly understood; however, it is speculated to be because when at least one of the metal layers is brought into a roughened state showing the above-mentioned surface roughness curve, electric field concentration at the time of high voltage application is suppressed, and deterioration of insulation reliability caused by electric field concentration is suppressed. In addition, the reason why an effect related to adhesion reliability is provided by the multilayer body of the present embodiment is not necessarily clearly understood; however, it is speculated to be because when at least one of the metal layers is brought into a roughened state showing the above-mentioned surface roughness curve, the interface between the metal layer and the insulation layer is likely to withstand thermal stress during a high-temperature treatment, and deterioration of adhesion reliability caused by a high-temperature treatment is suppressed.

Incidentally, in the present specification, the surface roughness curve is measured by using a laser microscope (VK-X1000 manufactured by KEYENCE CORPORATION).

The average length of elements (RSm) represents the average of the lengths of roughness curve elements at the reference length and has a value calculated from a surface roughness curve according to JIS B 0601. The maximum height (Rz) represents the sum of the height of the highest peak (Rp) and the depth of the deepest valley (Rv) in the roughness curve at the reference length and has a value calculated from a surface roughness curve according to JIS B 0601.

The phrase "showing a specific surface roughness curve" according to the present embodiment means that a specific surface roughness curve is measured on at least a portion of a target surface.

(Metal layers)

The metal material constituting the first metal layer is not particularly limited, and examples include aluminum, copper, iron, silver, gold, zinc, nickel, tin, and alloys including these metals. The first metal layer may be composed of one kind of metal material or may be composed of two or more kinds of metal materials.

It is preferable that the first metal layer contains at least one kind of metal atoms (M1) selected from the group consisting of aluminum, copper, iron, silver, gold, zinc, nickel, and tin. The metal atoms (M1) are preferably of at least one kind selected from the group consisting of aluminum, copper, and iron, and more preferably at least one selected from the group consisting of aluminum and copper.

The content of the metal atoms (M1) may be, for example, 50% by mass or more, preferably 60% by mass or more, more preferably 70% by mass or more, and even more preferably 80% by mass or more, based on the total amount of the first metal layer, and the content may also be 90% by mass or more or 100% by mass. That is, the content of the metal atoms (M1) may be, for example, 50 to 100% by mass, 60 to 100% by mass, 70 to 100% by mass, 80 to 100% by mass, or 90 to 100% by mass, based on the total amount of the first metal layer, or may be 100% by mass.

The first metal layer may be, for example, a metal plate. The thickness of the first metal layer is not particularly limited, and the thickness may be, for example, 0.01 mm or more and is preferably 0.1 mm or more, and more preferably 1.0 mm or more. In addition, the thickness of the first metal layer may be, for example, 10 mm or less and is preferably 5.0 mm or less, and more preferably 3.0 mm or less. That is, the thickness of the first metal layer may be, for example, 0.01 to 10 mm, 0.01 to 5.0 mm, 0.01 to 3.0 mm, 0.1 to 10 mm, 0.1 to 5.0 mm, 0.1 to 3.0 mm, 1.0 to 10 mm, 1.0 to 5.0 mm, or 1.0 to 3.0 mm.

A bonding surface (S1) of the first metal layer may be a roughening-treated surface. The method for the roughening treatment is not particularly limited, and a known roughening treatment can be utilized without particular limitation. Examples of the roughening treatment include a chemical etching treatment, a blasting treatment, and a buffing treatment.

The conditions for the roughening treatment are not particularly limited, and for example, conditions in which the bonding surface (S1) shows a surface roughness curve (C) that will be described below may be appropriately selected.

The metal material constituting the second metal layer is not particularly limited, and examples include aluminum, copper, iron, silver, gold, zinc, nickel, tin, and alloys including these metals. The second metal layer may be composed of one kind of metal material or may be composed of two or more kinds of metal materials.

It is preferable that the second metal layer contains at least one kind of metal atoms (M2) selected from the group consisting of aluminum, copper, iron, silver, gold, zinc, nickel, and tin. The metal atoms (M2) are preferably of at least one kind selected from the group consisting of aluminum, copper, and iron, and more preferably at least one selected from the group consisting of aluminum and copper.

The content of the metal atoms (M2) may be, for example, 50% by mass or more based on the total amount of the second metal layer, and the content is preferably 60% by mass or more, more preferably 70% by mass or more, and even more preferably 80% by mass or more, or may be 90% by mass or more or 100% by mass.

That is, the content of the metal atoms (M2) may be, for example, 50 to 100% by mass, 60 to 100% by mass, 70 to 100% by mass, 80 to 100% by mass, or 90 to 100% by mass, based on the total amount of the second metal layer, or may be 100% by mass.

The second metal layer may be, for example, a metal foil. The thickness of the second metal layer is not particularly limited, and the thickness may be, for example, 0.01 mm or more and is preferably 0.02 mm or more, and more preferably 0.03 mm or more. In addition, the thickness of the second metal layer may be, for example, 5.0 mm or less and is preferably 3.0 mm or less, and more preferably 1.0 mm or less. That is, the thickness of the second metal layer may be, for example, 0.01 to 5.0 mm, 0.01 to 3.0 mm, 0.01 to 1.0 mm, 0.02 to 5.0 mm, 0.02 to 3.0 mm, 0.02 to 1.0 mm, 0.03 to 5.0 mm, 0.03 to 3.0 mm, or 0.03 to 1.0 mm.

A bonding surface (S2) of the second metal layer may be a roughening-treated surface. The method for roughening treatment is not particularly limited, and a known roughening treatment can be utilized without particular limitation. Examples of the roughening treatment include a chemical etching treatment, a blasting treatment, and a buffing treatment.

The conditions for the roughening treatment are not particularly limited, and for example, conditions in which the bonding surface (S2) shows a surface roughness curve (C) that will be described below may be appropriately selected.

With regard to the first metal layer and the second metal layer, it is preferable that the bonding surface (S1 or S2) in contact with the insulation layer shows a surface roughness curve (C) having a reference length of 250 $\mu$m, an average length of elements RSm of 10 $\mu$m or more and 100 $\mu$m or less, and a maximum height Rz of 1 $\mu$m or more and 20 $\mu$m or less. When the average length of elements RSm is 10 $\mu$m or more and the maximum height Rz is 20 $\mu$m or less, electric field concentration at the time of high voltage application is suppressed, and deterioration of insulation reliability caused by electric field concentration is suppressed. In addition, when the average length of elements RSm is 100 $\mu$m or less and the maximum height Rz is 1 $\mu$m or more, the interface between the metal layer and the insulation layer is likely to withstand thermal stress during a high-temperature treatment, and deterioration of adhesion reliability caused by a high-temperature treatment is suppressed.

In the surface roughness curve (C), the average length of elements (RSm) is preferably 15 $\mu$m or more, and more preferably 20 $\mu$m or more. In addition, the average length of elements (RSm) is preferably 80 $\mu$m or less, and more preferably 60 $\mu$m or less. As a result, the above-described effects are provided more conspicuously. The average length of elements (RSm) may be, for example, 10 to 100 $\mu$m, 10 to 80 $\mu$m, 10 to 60 $\mu$m, 15 to 100 $\mu$m, 15 to 80 $\mu$m, 15 to 60 $\mu$m, 20 to 100 $\mu$m, 20 to 80 $\mu$m, or 20 to 60 $\mu$m.

In the surface roughness curve (C), the maximum height (Rz) is preferably 1.5 $\mu$m or more, and more preferably 2.0 $\mu$m or more. In addition, the maximum height (Rz) is preferably 15 $\mu$m or less, and more preferably 10 $\mu$m or less. As a result, the above-described effects are provided more conspicuously. The maximum height (Rz) may be, for example, 1 to 20 $\mu$m, 1 to 15 $\mu$m, 1 to 10 $\mu$m, 1.5 to 20 $\mu$m, 1.5 to 15 $\mu$m, 1.5 to 10 $\mu$m, 2.0 to 20 $\mu$m, 2.0 to 15 $\mu$m, or 2.0 to 10 $\mu$m.

In the surface roughness curve (C), it is preferable that the average length of elements (RSm) and the maximum height (Rz) satisfy the following Formula (A). As a result, the insulation reliability of the circuit board tends to be superior.

$$RSm \geq 1.25Rz + 12 \ \ldots \ (A)$$

(Insulation layer)

An insulation layer may be, for example, a layer containing an insulating resin cured body and an inorganic filler material.

The insulating resin cured body may be, for example, a cured body of a resin component containing a thermosetting resin and a curing agent.

Examples of the thermosetting resin include an epoxy resin, a silicone resin, a phenol resin, a cyanate resin, a melamine resin, a urea resin, a thermosetting polyimide resin, and an unsaturated polyester resin, and among these, an epoxy resin is preferred from the viewpoints of adhesiveness and electrical insulation properties.

The epoxy resin may be a resin that is curable by a curing agent. Examples of the epoxy resin include a bisphenol A type epoxy resin, a bisphenol S type epoxy resin, a bisphenol F type epoxy resin, a hydrogenated bisphenol A type epoxy resin, a polypropylene glycol type epoxy resin, a polytetramethylene glycol type epoxy resin, a naphthalene type epoxy resin, a phenylmethane type epoxy resin, a tetrakisphenolmethane type epoxy resin, a biphenyl type epoxy resin, an epoxy resin having a triazine ring, a bisphenol A alkylene oxide adduct type epoxy resin, a dicyclopentadiene type epoxy resin, a cresol novolac type epoxy resin, and a phenol novolac type epoxy resin. Regarding the epoxy resin, one kind thereof may be used alone, or two or more kinds thereof may be used in combination.

The curing agent may be a curing agent capable of curing a thermosetting resin and may be appropriately selected from known curing agents according to the type of the thermosetting resin.

When the thermosetting resin is an epoxy resin, examples of the curing agent (curing agent for epoxy resins) include an amine-based curing agent, a phenol-based curing agent, an acid anhydride-based curing agent, and a thiol-based curing agent.

The amine-based curing agent may be a curing agent that has an amino group and is capable of curing an epoxy resin. Examples of the amine-based curing agent include an aromatic amine-based curing agent, an aliphatic amine-based curing agent, and a dicyandiamide.

As the amine-based curing agent, any amine-based curing agent known as a curing agent for epoxy resins can be used without particular limitation. Regarding the amine-based curing agent, a commercially available product may be used, and for example, an aliphatic polyamine, an alicyclic polyamine, or an aromatic polyamine can be suitably used.

The phenol-based curing agent may be a curing agent that has a plurality of phenolic hydroxyl groups and is capable of curing an epoxy resin. Examples of the phenol-based curing agent include a novolac type phenol resin and a resole type phenol resin.

As the phenol-based curing agent, a phenol-based curing agent known as a curing agent for epoxy resins can be used without particular limitation. Regarding the phenol-based curing agent, a commercially available product may be used, and for example, phenol novolac, xylylene novolac, and bisphenol A type novolac can be suitably used.

The acid anhydride-based curing agent may be a curing agent that has a structure in which two carboxyl groups are dehydrated and condensed, and is capable of curing an epoxy resin. Examples of the acid anhydride-based curing agent include an aliphatic acid anhydride and an aromatic acid anhydride.

As the acid anhydride-based curing agent, an acid anhydride-based curing agent known as a curing agent for epoxy resins can be used without particular limitation. Regarding the acid anhydride-based curing agent, a commercially available product may be used, and for example, a phthalic anhydride derivative and a maleic anhydride derivative can be suitably used.

The thiol-based curing agent may be a curing agent that has a plurality of mercapto groups and is capable of curing an epoxy resin. Examples of the thiol-based curing agent include an aliphatic thiol-based curing agent and an aromatic thiol-based curing agent.

As the thiol-based curing agent, a thiol-based curing agent known as a curing agent for epoxy resins can be used without particular limitation. Regarding the thiol-based curing agent, a commercially available product may be used, and for example, an aliphatic polythioether, an aliphatic polythioester, and an aromatic-containing polythioether can be suitably used.

The content of the curing agent in the resin component may be, for example, 1.0 part by mass or more with respect to 100 parts by mass of the thermosetting resin, and the content is preferably 10 parts by mass or more, and more preferably 20 parts by mass or more, or may be 50 parts by mass or more. In addition, the content of the curing agent may be, for example, 300 parts by mass or less with respect to 100 parts by mass of the thermosetting resin, and the content is preferably 200 parts by mass or less, and more preferably 150 parts by mass or less, or may be 0 parts by mass. That is, the content of the curing agent in the resin component may be, for example, 0 to 300 parts by mass, 0 to 200 parts by mass, 0 to 150 parts by mass, 1.0 to 300 parts by mass, 1.0 to 200 parts by mass, 1.0 to 150 parts by mass, 10 to 300 parts by mass, 10 to 200 parts by mass, 10 to 150 parts by mass, 20 to 300 parts by mass, 20 to 200 parts by mass, 20 to 150 parts by mass, 50 to 300 parts by mass, 50 to 200 parts by mass, or 50 to 150 parts by mass, with respect to 100 parts by mass of the thermosetting resin.

The resin component may further contain other components in addition to the above-described ones. The resin component may further contain, for example, a curing accelerator, a discoloration inhibitor, a surfactant, a coupling agent, a colorant, a viscosity modifier, an oxidation inhibitor, and an ion scavenger, as necessary.

The content of the other components in the resin component may be, for example, 10% by mass or less, and the content is preferably 5% by mass or less or may be 0% by mass. That is, the total amount of the thermosetting resin and the curing agent in the resin component may be, for example, 90% by mass or more, and the total amount is preferably 95% by mass or more or may be 100% by mass.

The insulating resin cured body is a cured body of the resin component.

The glass transition point of the insulating resin cured body is preferably 125°C or higher, and more preferably 150°C or higher. As a result, the insulation resistance at high temperatures of the cured body is improved, and an insulation layer having more excellent insulation reliability at high temperatures can be formed. In addition, the upper limit of the glass transition point of the insulating resin cured body is not particularly limited; however, the upper limit is preferably 400°C or lower, and more preferably 350°C or lower. As a result, the flexibility of the cured body is further improved, and an insulation layer having more excellent stress relaxation properties can be formed. That is, the glass transition point of the insulating resin cured body may be, for example, 125 to 400°C, 125 to 350°C, 150 to 400°C, or 150 to 350°C.

In the present specification, the glass transition point of the insulating resin cured body shows a value measured by the following method.

<Method for measuring glass transition point>

(1) Production of measurement sample

An insulating resin cured body is cut out into a plate shape with a size of 0.1 mm × 5 mm × 40 mm to create a measurement sample.

(2) Measurement of glass transition point

The loss tangent (tan δ) is measured by using a dynamic viscoelasticity measuring instrument (manufactured by TA Instruments, "RSA 3") over the temperature range of 30°C to +300°C under the conditions of a frequency of 10 Hz and a temperature increase rate of 10°C/min, and the temperature at which the value of the loss tangent becomes the maximum is defined as the glass transition point.

The content of the insulating resin cured body in the insulation layer may be, for example, 1.0% by volume or more based on the total volume of the insulation layer, and the content is preferably 10% by volume or more, and more preferably 20% by volume or more. In addition, the content of the insulating resin cured body in the insulation layer may be, for example, 99% by volume or less based on the total volume of the insulation layer, and the content is preferably 90% by volume or less, and more preferably 80% by volume or less. That is, the content of the insulating resin cured body in the insulation layer may be, for example, 1.0 to 99% by volume, 1.0 to 90% by volume, 1.0 to 80% by volume, 10 to 99% by volume, 10 to 90% by volume, 10 to 80% by volume, 20 to 99% by volume, 20 to 90% by volume, or 20 to 80% by volume, based on the total volume of the insulation layer.

Examples of the inorganic filler material include inorganic filler materials composed of aluminum oxide, silica, aluminum nitride, silicon nitride, and boron nitride.

From the viewpoint of suppressing deterioration of electrical insulation properties in a high-temperature and high-humidity environment due to hydrolysis of the inorganic material, it is preferable that the inorganic filler material contains an inorganic material selected from the group consisting of aluminum oxide, silica, silicon nitride, and boron nitride as a main component. The content of the inorganic material in the inorganic filler material is preferably 60% by mass or more, more preferably 70% by mass or more, and even more preferably 80% by mass or more, based on the total amount of the inorganic filler material.

Incidentally, for example, when the inorganic filler material includes a large amount of aluminum nitride, hydrolysis of aluminum nitride may occur in a high-temperature and high-humidity environment, and electrical insulation properties may be deteriorated. For this reason, the content of aluminum nitride in the inorganic filler material is preferably 40% by mass or less, more preferably 30% by mass or less, and even more preferably 20% by mass or less, based on the total amount of the inorganic filler material. As described above, by containing an inorganic material selected from the group consisting of aluminum oxide, silica, silicon nitride, and boron nitride as a main component, such deterioration of electrical insulation properties caused by hydrolysis is conspicuously suppressed.

The shape of the inorganic filler material is not particularly limited, and the shape may be a particulate shape, a scale shape, a polygonal shape, or the like, while a particulate shape is preferred.

The maximum particle size of the inorganic filler material may be, for example, 250 μm or less and is preferably

200 $\mu$m or less, and more preferably 150 $\mu$m or less. As a result, the electrical insulation properties of the insulation layer tend to be further improved. In addition, the minimum particle size of the inorganic filler material is not particularly limited; however, from the viewpoint that the thermal conductivity of the insulation layer is further improved, the minimum particle size may be, for example, 0.05 $\mu$m or more and is preferably 0.1 $\mu$m or more. Incidentally, in the present specification, the maximum particle size and the minimum particle size of the inorganic filler material represent the d90 diameter and the d10 diameter in a volume-based particle size distribution, and these are measured with a laser diffraction type particle size distribution measuring apparatus. That is, the maximum particle size of the inorganic filler material may be, for example, 0.05 to 250 $\mu$m, 0.05 to 200 $\mu$m, 0.05 to 150 $\mu$m, 0.1 to 250 $\mu$m, 0.1 to 200 $\mu$m, or 0.1 to 150 $\mu$m.

The content of the inorganic filler material in the insulation layer may be, for example, 1.0% by volume or more based on the total volume of the insulation layer, and the content is preferably 10% by volume or more, and more preferably 20% by volume or more. In addition, the content of the inorganic filler material in the insulation layer may be, for example, 99% by volume or less based on the total volume of the insulation layer, and the content is preferably 90% by volume or less, and more preferably 80% by volume or less. That is, the content of the inorganic filler material in the insulation layer may be, for example, 1.0 to 99% by volume, 1.0 to 90% by volume, 1.0 to 80% by volume, 10 to 99% by volume, 10 to 90% by volume, 10 to 80% by volume, 20 to 99% by volume, 20 to 90% by volume, or 20 to 80% by volume, based on the total volume of the insulation layer.

The insulation layer may be formed by, for example, curing a coating film of a composition containing the resin component and the inorganic filler material described above.

Curing of the coating film can be carried out by, for example, a heat treatment. The heat treatment may be performed in one stage or may be carried out in two stages. By performing a heat treatment in two stages, an insulation layer can be formed by way of a semi-cured body of the coating film. The temperature and time of the heat treatment may be appropriately changed according to the types of the thermosetting resin and the curing agent, and the like.

In the case of performing the heat treatment in one stage, the temperature of the heat treatment may be, for example, 40 to 250°C and is preferably 70 to 180°C, and the time for the heat treatment may be, for example, 0.5 to 48 hours and is preferably 1 to 6 hours.

In the case of performing the heat treatment in two stages, the temperature of the heat treatment in a first stage (first heat treatment) may be, for example, 40 to 150°C and is preferably 50 to 100°C, and the time for the first heat treatment may be, for example, 0.2 to 8 hours and is preferably 0.5 to 5 hours. In addition, the temperature of the heat treatment in a second stage (second heat treatment) may be, for example, 70 to 250°C and is preferably 120 to 180°C, and the time for the heat treatment may be, for example, 0.5 to 9 hours and is preferably 1 to 6 hours.

The insulation layer may be formed by, for example, disposing a coating film of the above-described composition or a semi-cured body of the coating film between the first metal layer and the second metal layer and heating and pressurizing the assembly. The pressurization conditions are not particularly limited. Pressurization may be performed at a surface pressure of, for example, 1 MPa or more, preferably 5 MPa or more, and more preferably 8 MPa or more. In addition, pressurization may be performed at a surface pressure of, for example, 30 MPa or less, preferably 25 MPa or less, and more preferably 20 MPa or less. That is, the surface pressure may be, for example, 1 to 30 MPa, 1 to 25 MPa, 1 to 20 MPa, 5 to 30 MPa, 5 to 25 MPa, 5 to 20 MPa, 8 to 30 MPa, 8 to 25 MPa, or 8 to 20 MPa.

The thickness of the insulation layer is not particularly limited; however, from the viewpoint of electrical insulation properties, the thickness may be, for example, 30 $\mu$m or more and is preferably 50 $\mu$m or more, and more preferably 80 $\mu$m or more. In addition, from the viewpoint of heat resistance, the thickness of the insulation layer may be, for example, 500 $\mu$m or less and is preferably 300 $\mu$m or less, and more preferably 200 $\mu$m or less. That is, the thickness of the insulation layer may be, for example, 30 to 500 $\mu$m, 30 to 300 $\mu$m, 30 to 200 $\mu$m, 50 to 500 $\mu$m, 50 to 300 $\mu$m, 50 to 200 $\mu$m, 80 to 500 $\mu$m, 80 to 300 $\mu$m, or 80 to 200 $\mu$m.

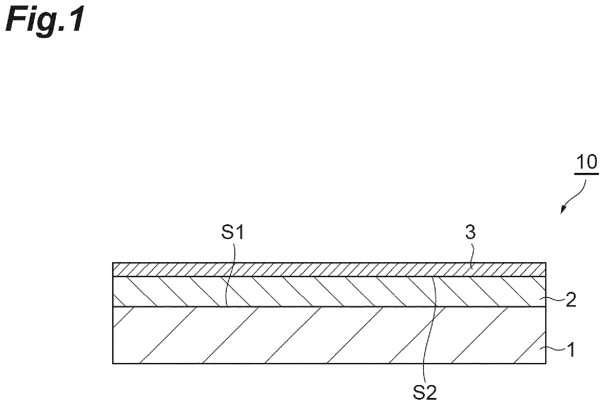

FIG. 1 is a cross-sectional view illustrating a suitable embodiment of a multilayer body. A multilayer body 10 shown in FIG. 1 includes a first metal layer 1, an insulation layer 2 disposed on the first metal layer 1, and a second metal layer 3 disposed on the insulation layer 2. The first metal layer 1 has a bonding surface S1 in contact with the insulation layer 2. The second metal layer 3 has a bonding surface S2 in contact with the insulation layer 2.

At least one of the bonding surface S1 and the bonding surface S2 shows the above-mentioned surface roughness curve (C).

By processing the second metal layer 3 of the multilayer body 10 into a predetermined shape to form a metal circuit part, a circuit board can be easily produced.

With regard to the bonding surface S1 of the first metal layer 1, it is preferable that a portion facing the metal circuit part shows the above-mentioned surface roughness curve. In addition, with regard to the bonding surface S2 of the second metal layer 3, it is preferable that a portion remaining as the metal circuit part shows the above-mentioned surface roughness curve (C). In other words, it is preferable that the metal circuit part is formed at a position facing the portion of the bonding surface S1 showing the above-mentioned surface roughness curve (C). In addition, it is preferable that the metal circuit part is formed such that the portion of the bonding surface S2 showing the above-mentioned surface roughness curve (C) remains.

The method for forming the metal circuit part is not particularly limited, and a known processing method may be applied.

[Circuit board]

A circuit board of the present embodiment includes a metal layer, an insulation layer disposed on the metal layer, and a metal circuit part disposed on the insulation layer.

With regard to the circuit board of the present embodiment, at least one of the bonding surface (S1) between the metal layer and the insulation layer, and the bonding surface (S3) between the metal circuit part and the insulation layer, shows a surface roughness curve (C) having a reference length of 250 $\mu$m, an average length of elements RSm of 10 $\mu$m or more and 100 $\mu$m or less, and a maximum height Rz of 1 $\mu$m or more and 20 $\mu$m or less.

The circuit board of the present embodiment has excellent insulation reliability under the conditions of high voltage application (particularly, an effect of suppressing deterioration of electrical insulation properties over time) and can maintain high adhesion reliability even after a high-temperature treatment. The reason why an effect related to insulation reliability is provided by the circuit board of the present embodiment is not necessarily clearly understood; however, it is speculated to be because when at least one of the metal layer and the metal circuit part is brought into a roughened state showing the above-mentioned surface roughness curve, electric field concentration at the time of high voltage application is suppressed, and deterioration of insulation reliability caused by electric field concentration is suppressed. In addition, the reason why an effect related to adhesion reliability is provided by the circuit board of the present embodiment is not necessarily clearly understood; however, it is speculated to be because when at least one of the metal layer and the metal circuit part is brought into a roughened state showing the above-mentioned surface roughness curve, the interface between the metal layer or the metal circuit part and the insulation layer is likely to withstand thermal stress during a high-temperature treatment, and deterioration of adhesion reliability caused by a high-temperature treatment is suppressed.

The circuit board of the present embodiment may be a circuit board produced by removing a portion of the second metal layer of the above-mentioned multilayer body.

With regard to the circuit board of the present embodiment, the surface roughness curve (C) may be similar to the surface roughness curve (C) of the above-mentioned multilayer body.

As the metal layer in the circuit board of the present embodiment, the same metal layer as the first metal layer in the above-described multilayer body can be mentioned as an example.

As the insulation layer in the circuit board of the present embodiment, the same insulation layer as the insulation layer in the above-described multilayer body can be mentioned as an example.

The metal circuit part in the circuit board of the present embodiment may be the part remaining after removing a portion of the second metal layer in the above-mentioned multilayer body. That is, the material constituting the metal circuit part and the thickness of the metal circuit part may be the same as the material constituting the second metal layer and the thickness of the second metal layer.

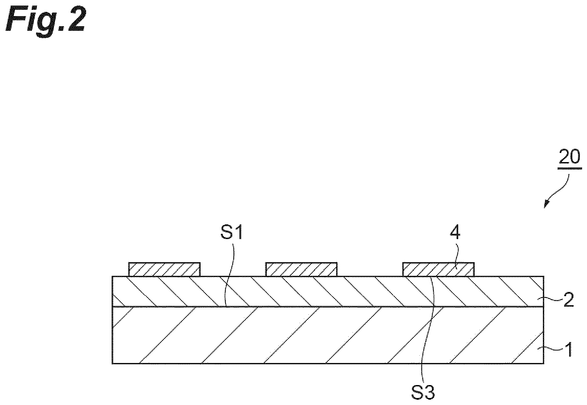

FIG. 2 is a cross-sectional view illustrating a suitable embodiment of a circuit board. A circuit board 20 shown in FIG. 2 is a circuit board produced from the multilayer body shown in FIG. 1 and includes a first metal layer 1, an insulation layer 2 disposed on the first metal layer 1, and a metal circuit part 4 disposed on the insulation layer 2. The first metal layer 1 has a bonding surface S1 in contact with the insulation layer 2. The metal circuit part 4 has a bonding surface S3 in contact with the insulation layer 2.

At least one of the bonding surface S1 and the bonding surface S3 shows the above-mentioned surface roughness curve (C).

Thus, suitable embodiments of the present invention have been described; however, the present invention is not intended to be limited to the above-described embodiments.

The present invention may relate to, for example, a method for producing a multilayer body, the method including a first preparation step of preparing a first metal layer having a roughened surface in which the average length of elements RSm in a surface roughness curve with a reference length of 250 $\mu$m is 10 $\mu$m or more and 100 $\mu$m or less, and the maximum height Rz is 1 $\mu$m or more and 20 $\mu$m or less; a second preparation step of preparing a second metal layer having a roughened surface in which the average length RSm in a surface roughness curve with a reference length of 250 $\mu$m is 10 $\mu$m or more and 100 $\mu$m or less, and the maximum height Rz is 1 $\mu$m or more and 20 $\mu$m or less; a third preparation step of preparing a composition including a resin component containing a thermosetting resin and a curing agent, and an inorganic filler material; a disposition step of disposing a coating film of the composition or a semi-cured body thereof between the first metal layer and the second metal layer, which are disposed such that the roughened surfaces face each other; and a heating and pressurization step of forming an insulation layer by heating and pressurization to obtain a multilayer body including the first metal layer, the insulation layer, and the second metal layer.

The first preparation step may be a step of subjecting one surface of the metal layer to a roughening treatment and forming a first metal layer. In addition, the first preparation step may be a step of measuring, for a metal layer having a roughened surface, a surface roughness curve in which the reference length of the roughened surface is 250 μm, and selecting a first metal layer based on the average length of elements RSm and the maximum height Rz in the surface roughness curve.

The second preparation step may be a step of subjecting one surface of the metal layer to a roughening treatment and forming a second metal layer. In addition, the second preparation step may be a step of measuring, for a metal layer having a roughened surface, a surface roughness curve in which the reference length of the roughened surface is 250 μm, and selecting a second metal layer based on the average length of elements RSm and the maximum height Rz in the surface roughness curve.

The present invention may also relate to a selection method of selecting a multilayer body including a first metal layer, an insulation layer disposed on the first metal layer, and a second metal layer disposed on the insulation layer.

The above-described selection method may include a first selection step of measuring a surface roughness curve with a reference length of 250 μm for the bonding surface (S1) of the first metal layer in contact with the insulation layer, and selecting a multilayer body in which the average length RSm in the surface roughness curve is 10 μm or more and 100 μm or less, and the maximum height Rz is 1 μm or more and 20 μm or less.

In addition, the selection method may include a second selection step of measuring a surface roughness curve with a reference length of 250 μm for the bonding surface (S2) of the second metal layer in contact with the insulation layer, and selecting a multilayer body in which the average length RSm in the surface roughness curve is 10 μm or more and 100 μm or less, and the maximum height Rz is 1 μm or more and 20 μm or less.

The selection method may include any one of the first selection step and the second selection step or may include both of them.

The present invention may further relate to a selection method for selecting a circuit board including a metal layer, an insulation layer disposed on the metal layer, and a metal circuit part disposed on the insulation layer.

The above-described selection method may include a first selection step of measuring a surface roughness curve with a reference length of 250 μm for the bonding surface (S1) of the metal layer in contact with the insulation layer, and selecting a circuit board in which the average length RSm in the surface roughness curve is 10 μm or more and 100 μm or less, and the maximum height Rz is 1 μm or more and 20 μm or less.

In addition, the selection method may include a second selection step of measuring a surface roughness curve with a reference length of 250 μm for the bonding surface (S3) between the metal circuit part in contact with the insulation layer, and selecting a circuit board in which the average length RSm in the surface roughness curve is 10 μm or more and 100 μm or less, and the maximum height Rz is 1 μm or more and 20 μm or less.

The selection method may include any one of the first selection step and the second selection step or may include both of them.

## Examples

The present invention will be described in more detail below by way of Examples; however, the present invention is not intended to these Examples.

(Example 1)

<Production of composition>

100 parts by mass of a naphthalene type epoxy resin HP-4032D (manufactured by DIC Corporation, specific weight 1.2 g/cm$^3$) as a thermosetting resin, and 12.4 parts by mass of a phenol novolac resin VH-4150 (manufactured by DIC Corporation, specific weight 1.1 g/cm$^3$) as a curing agent were stirred at 170°C to obtain a mixture. Next, the mixture was mixed under stirring with 214.8 parts by mass of boron nitride (manufactured by Denka Company Limited, specific weight 2.27 g/cm$^3$), 0.7 parts by mass of a wetting dispersant DISPER BYK111 (manufactured by BYK Japan KK, specific weight 1.1 g/cm$^3$), 0.6 parts by mass of TPP (manufactured by HOKKO CHEMICAL INDUSTRY CO., LTD., specific weight 1.1 g/cm$^3$) as a curing accelerator, and 1.0 part by mass of an imidazole compound 2PHZ-PW (manufactured by SHIKOKU CHEMICALS CORPORATION, specific weight 1.1 g/cm$^3$) for 15 minutes in a planetary mixer, and a composition was produced. Incidentally, the volume-based content of each component in the composition is 43.6% by volume for the naphthalene type epoxy resin, 5.9% by volume for the phenol novolac resin, 49.4% by volume for boron nitride, 0.3% by volume for the wetting dispersant, 0.3% by volume for the curing accelerator, and 0.5% by volume for the imidazole compound.

<Production of multilayer body>

The obtained composition was applied on a film made of polyethylene terephthalate (PET) having a thickness of 0.038 mm such that the thickness after semi-curing was 0.20 mm, the composition was heated and dried at 100°C for 70 minutes, and a semi-cured body (B-stage sheet) was produced. The obtained semi-cured body was peeled off from the PET film and was disposed on a roughened surface of a metal plate (copper plate having a thickness of 2.0 mm). Next, a roughened surface of a metal foil (copper foil having a thickness of 0.5 mm) was disposed on the semi-cured body, subsequently the assembly was heated and cured at 180°C for 410 minutes while a surface pressure of 10 MPa was applied thereon by using a press machine, and a multilayer body was obtained. The thickness of the insulation layer in the multilayer body was 125 $\mu$m.

Incidentally, for the roughened surfaces of the metal plate and the metal foil, a surface roughness curve was measured by the method that will be described below, and the average length of elements RSm and the maximum height Rz were determined. The results are shown in Table 1. In addition, the glass transition temperature of the resin cured body constituting the insulation layer was measured. The results are shown in Table 1.

<Production of circuit board>

A predetermined position on the metal foil of the multilayer body was masked with an etching resist, and then the copper foil was etched by using a mixed solution of sulfuric acid-hydrogen peroxide as an etching solution. The etching resist was removed, and washing and drying were performed to obtain a metal base circuit board having a circular electrode (copper foil) with a diameter of 20 mm. For the obtained metal base circuit board, evaluation of insulation reliability and adhesion reliability was performed by the following methods. The results are shown in Table 1.

<Measurement of surface roughness curve>

The roughened surfaces of the metal plate and the metal foil were observed by using a laser microscope VK-X1000 (manufactured by KEYENCE CORPORATION), a surface roughness curve having a reference length of 250 $\mu$m was obtained by line roughness measurement of data analysis software, and then RSm and Rz were calculated by the method specified in JIS B 0601. As measurement conditions, the objective lens was set to $\times$50, the eyepiece was set to about $\times$20, and data at one site was acquired.

<Evaluation of insulation reliability>

The obtained metal base circuit board was subjected to a high-temperature high-pressure bias test (V-t) in an environment at 125°C under test conditions of applying a direct current voltage of 10 kV between the circular electrode and the metal plate. The time taken from the initiation of voltage application to the time point when the leakage current value measured with a withstand voltage tester reached 10 mA or greater, was designated as durability time. When the durability time was 50 minutes or more, it can be said that the circuit board is a metal base circuit board having excellent insulation reliability in a high-temperature environment.

<Evaluation of adhesion reliability>

First, as a destructive test, the circuit board was subjected to a heating treatment for 5 minutes on a hot plate at 285°C and then cooled to room temperature, and then the metal plate and the metal foil were peeled off from the insulation layer. In this destructive test, adhesion reliability was evaluated such that a case in which cohesive failure of the insulation layer occurred was rated as A; and a case in which interfacial failure occurred at the interface between the metal plate and the insulation layer or the interface between the metal foil and the insulation layer was rated as B.

(Examples 2 to 8 and Comparative Examples 1 to 4)

Production of multilayer bodies and production of circuit boards were carried out in the same manner as in Example 1, except that metal plates and metal foils in which the average length of elements RSm and the maximum height Rz on the roughened surfaces had the values indicated in Table 1, Table 2, or Table 3 were used as the metal plates and metal foils. For the obtained circuit boards, insulation reliability and adhesion reliability were evaluated in the same manner as in Example 1. The results are shown in Table 1, Table 2, or Table 3.

(Example 9)

<Production of composition>

100 parts by mass of a bisphenol A type epoxy resin EXA-850CRP (manufactured by DIC Corporation, specific weight 1.2 g/cm$^3$) as a thermosetting resin, 34 parts by mass of diaminophenylmethane H-84B (manufactured by D Achmex Co., Ltd., specific gravity 1.1 g/cm$^3$) as a curing agent, and 900 parts by mass of alumina AS30-1 (manufactured by Showa Denko K.K., specific gravity 3.95 g/cm$^3$) were stirred and mixed for 15 minutes in a planetary mixer, and a composition was produced. Incidentally, the volume-based content of each component in the composition was 24.4% by volume for the bisphenol A type epoxy resin, 9.0% by volume for the curing agent, and 66.6% by volume for the alumina AS30-1.

<Production of multilayer body>

The obtained composition was applied on a film made of polyethylene terephthalate (PET) having a thickness of 0.038 mm such that the thickness after semi-curing was 0.20 mm, the composition was heated and dried at 100°C for 20 minutes, and as a result, a semi-cured body (B-stage sheet) was produced. The obtained semi-cured body was peeled off from the PET film and was disposed on a roughened surface of a metal plate (aluminum plate having a thickness of 1.5 mm). Next, a roughened surface of a metal foil (copper foil having a thickness of 0.5 mm) was disposed on the semi-cured body, subsequently the assembly was heated and cured at 180°C for 410 minutes while a surface pressure of 10 MPa was applied thereon by using a press machine, and a multilayer body was obtained. The thickness of the insulation layer in the multilayer body was 130 μm.

Incidentally, for the roughened surfaces of the metal plate and the metal foil, a surface roughness curve was measured by the same method as that used in Example 1, and the average length of elements RSm and the maximum height Rz were determined. The results are shown in Table 2. In addition, the glass transition temperature of the resin cured body constituting the insulation layer was measured. The results are shown in Table 2.

<Production of circuit board>

A predetermined position on the metal foil of the multilayer body was masked with an etching resist, and then the copper foil was etched by using a mixed solution of sulfuric acid-hydrogen peroxide as an etching solution. The etching resist was removed, and washing and drying were performed to obtain a metal base circuit board having a circular electrode (copper foil) with a diameter of 20 mm. For the obtained metal base circuit board, evaluation of insulation reliability and adhesion reliability was performed in the same manner as in Example 1. The results are shown in Table 2.

[Table 1]

| | | Example 1 | Example 2 | Example 3 | Example 4 | Example 5 | Example 6 |
|---|---|---|---|---|---|---|---|
| Metal plate | Rz(μm) | 6.2 | 4.7 | 4.9 | 3.2 | 3.6 | 3.0 |
| | RSm(μm) | 19.4 | 55.8 | 20.6 | 14.3 | 29.8 | 18.7 |
| Metal foil | Rz(μm) | 6.1 | 4.5 | 5.0 | 3.1 | 3.7 | 3.1 |
| | RSm(μm) | 19.2 | 55.4 | 20.8 | 14.1 | 29.9 | 18.9 |
| Glass transition point of resin cured body (°C) | | 185 | 185 | 185 | 185 | 185 | 185 |
| Durability time (minutes) | | 64 | 526 | 459 | 198 | 521 | 589 |
| Adhesion reliability | | A | A | A | A | A | A |

[Table 2]

| | | Example 7 | Example 8 | Example 9 |
|---|---|---|---|---|
| Metal plate | Rz(μm) | 22.5 | 16.3 | 11.9 |
| | RSm(μm) | 15.2 | 43.0 | 27.4 |
| Metal foil | Rz(μm) | 4.9 | 4.9 | 1.0 |
| | RSm(μm) | 21.0 | 20.6 | 24.2 |
| Glass transition point of resin cured body (°C) | | 185 | 185 | 165 |
| Durability time (minutes) | | 60 | 396 | 373 |

(continued)

|  | Example 7 | Example 8 | Example 9 |
|---|---|---|---|
| Adhesion reliability | A | A | A |

[Table 3]

|  |  | Comparative Example 1 | Comparative Example 2 | Comparative Example 3 | Comparative Example 4 |
|---|---|---|---|---|---|
| Metal plate | Rz($\mu$m) | 22.7 | 18.9 | 0.7 | 1.1 |
|  | RSm ($\mu$m) | 15.3 | 8.5 | 73.0 | 110.0 |
| Metal foil | Rz($\mu$m) | 22.4 | 18.7 | 0.7 | 1.2 |
|  | RSm ($\mu$m) | 15.1 | 8.2 | 75.0 | 112.0 |
| Glass transition point of resin cured body (°C) |  | 185 | 185 | 185 | 185 |
| Durability time (minutes) |  | 10 | 25 | ≥600 | ≥600 |
| Adhesion reliability |  | A | A | B | B |

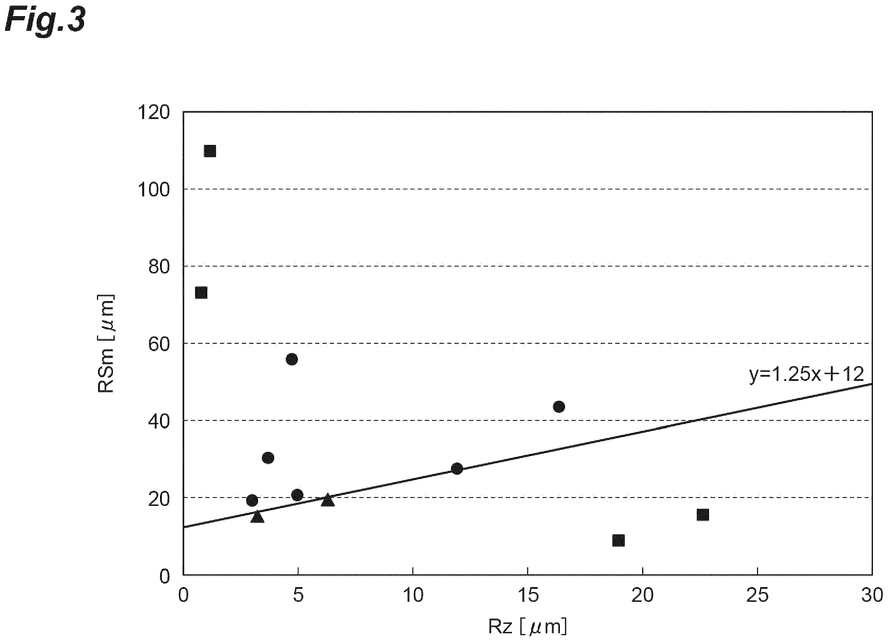

Incidentally, FIG. 3 is a diagram showing the relationship between RSm and Rz of the metal plates of Examples 1 to 6, 8, and 9 and Comparative Examples 1 to 4. In FIG. 3, a point described as a circle indicates Example 2, 3, 5, 6, 8, or 9; a point described as a triangle indicates Example 1 or 4; and a point described as a square indicates one of Comparative Examples 1 to 4.

From the results shown in Tables 1 to 3 and FIG. 3, it was verified that when RSm and Rz satisfy Formula (A), a circuit member having especially excellent insulation reliability is obtained.

$$RSm \geq 1.25Rz + 12 \ ... \ (A)$$

**Reference Signs List**

1: first metal layer, 2: insulation layer, 3: second metal layer, 4: metal circuit part, 10: multilayer body, 20: circuit board.

**Claims**

1. A multilayer body comprising:

   a first metal layer;
   an insulation layer disposed on the first metal layer; and
   a second metal layer disposed on the insulation layer,
   wherein at least one of a bonding surface of the first metal layer in contact with the insulation layer and a bonding surface of the second metal layer in contact with the insulation layer shows a surface roughness curve having a reference length of 250 $\mu$m, an average length of elements RSm of 10 $\mu$m or more and 100 $\mu$m or less, and a maximum height Rz of 1 $\mu$m or more and 20 $\mu$m or less.

2. The multilayer body according to claim 1, wherein both the bonding surface of the first metal layer in contact with the insulation layer and the bonding surface of the second metal layer in contact with the insulation layer show the surface roughness curve.

3. The multilayer body according to claim 1 or 2, wherein the insulation layer has a thickness of 30 $\mu$m or more.

4. The multilayer body according to claim 1 or 2, wherein the first metal layer and the second metal layer contain 60% by mass or more of at least one kind of metal atoms selected from the group consisting of aluminum, copper, iron, silver, gold, zinc, nickel, and tin.

5. The multilayer body according to claim 1 or 2, wherein the insulation layer contains an insulating resin cured body and an inorganic filler material.

6. The multilayer body according to claim 1 or 2, wherein the average length of elements RSm and the maximum height Rz satisfy the following Formula (A):

$$RSm \geq 1.25Rz + 12 \ldots (A).$$

7. A circuit board comprising:

a metal layer;
an insulation layer disposed on the metal layer; and
a metal circuit part disposed on the insulation layer,
wherein at least one of a bonding surface of the metal layer in contact with the insulation layer and a bonding surface of the metal circuit part in contact with the insulation layer shows a surface roughness curve having a reference length of 250 $\mu$m, an average length of elements RSm of 10 $\mu$m or more and 100 $\mu$m or less, and a maximum height Rz of 1 $\mu$m or more and 20 $\mu$m or less.

8. The circuit board according to claim 7, wherein both the bonding surface of the metal layer in contact with the insulation layer and the bonding surface of the metal circuit part in contact with the insulation layer show the surface roughness curve.

9. The circuit board according to claim 7 or 8, wherein the average length of elements RSm and the maximum height Rz satisfy the following Formula (A):

$$RSm \geq 1.25Rz + 12 \ldots (A).$$

10. A method for producing a circuit board, the method comprising:

a step of preparing the multilayer body according to claim 1 or 2; and
a step of removing a portion of the first metal layer or a portion of the second metal layer of the multilayer body to form a metal circuit part.

# Fig.1

*Fig.2*

**Fig.3**

EP 4 333 567 A1

**INTERNATIONAL SEARCH REPORT**

| International application No. |
|---|
| **PCT/JP2022/019428** |

**A. CLASSIFICATION OF SUBJECT MATTER**

*H05K 3/44*(2006.01)i; *B32B 15/04*(2006.01)i; *B32B 15/08*(2006.01)i; *H05K 1/03*(2006.01)i; *H05K 1/05*(2006.01)i
FI: H05K3/44 Z; B32B15/04 Z; B32B15/08 J; B32B15/08 U; H05K1/03 630H; H05K1/05 A

According to International Patent Classification (IPC) or to both national classification and IPC

**B. FIELDS SEARCHED**

Minimum documentation searched (classification system followed by classification symbols)

H05K3/44; B32B15/04; B32B15/08; H05K1/03; H05K1/05

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2020/090688 A1 (PANASONIC INTELLECTUAL PROPERTY MANAGEMENT CO., LTD.) 07 May 2020 (2020-05-07) paragraphs [0011]-[0077], fig. 1 | 1-4, 6-10 |
| Y | | 5 |
| X | WO 2012/046804 A1 (FURUKAWA ELECTRIC CO., LTD.) 12 April 2012 (2012-04-12) paragraphs [0030]-[0047] | 1-4, 6-10 |
| Y | | 5 |
| Y | JP 2015-127410 A (SHIKOKU CHEM. CORP.) 09 July 2015 (2015-07-09) paragraphs [0021], [0024] | 5 |
| A | JP 2020-136469 A (NGK SPARK PLUG CO., LTD.) 31 August 2020 (2020-08-31) | 1-10 |
| A | JP 2013-62500 A (FUJIFILM CORP.) 04 April 2013 (2013-04-04) | 1-10 |
| A | WO 2016/151832 A1 (HITACHI, LTD.) 29 September 2016 (2016-09-29) | 1-10 |
| A | WO 2019/160122 A1 (KYOCERA CORP.) 22 August 2019 (2019-08-22) | 1-10 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **19 July 2022** | **02 August 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

International application No.

**PCT/JP2022/019428**

| C. | DOCUMENTS CONSIDERED TO BE RELEVANT | |
|---|---|---|
| Category* | Citation of document, with indication, where appropriate, of the relevant passages | Relevant to claim No. |
| P, X | WO 2021/131268 A1 (SHIN-ETSU POLYMER CO., LTD.) 01 July 2021 (2021-07-01) paragraphs [0010]-[0077] | 1-10 |

Form PCT/ISA/210 (second sheet) (January 2015)

**INTERNATIONAL SEARCH REPORT**
Information on patent family members

International application No.

**PCT/JP2022/019428**

| Patent document cited in search report | | | Publication date (day/month/year) | Patent family member(s) | | | Publication date (day/month/year) |
|---|---|---|---|---|---|---|---|
| WO | 2020/090688 | A1 | 07 May 2020 | US | 2021/0400810 | A1 | |
| | | | | paragraphs [0016]-[0104], fig. 1 | | | |
| | | | | CN | 112839812 | A | |
| | | | | KR | 10-2021-0084475 | A | |
| | | | | TW | 202029848 | A | |
| WO | 2012/046804 | A1 | 12 April 2012 | US | 2013/0220679 | A1 | |
| | | | | paragraphs [0056]-[0101] | | | |
| | | | | EP | 2615196 | A1 | |
| | | | | CN | 103154327 | A | |
| | | | | KR | 10-2013-0098359 | A | |
| | | | | TW | 201229322 | A | |
| JP | 2015-127410 | A | 09 July 2015 | US | 2016/0289237 | A1 | |
| | | | | paragraphs [0219], [0230] | | | |
| JP | 2020-136469 | A | 31 August 2020 | (Family: none) | | | |
| JP | 2013-62500 | A | 04 April 2013 | WO | 2013/027847 | A1 | |
| WO | 2016/151832 | A1 | 29 September 2016 | (Family: none) | | | |
| WO | 2019/160122 | A1 | 22 August 2019 | US | 2020/0402773 | A1 | |
| | | | | US | 2020/0402771 | A1 | |
| | | | | EP | 3754046 | A1 | |
| | | | | EP | 3754047 | A1 | |
| | | | | KR | 10-2020-0106531 | A | |
| | | | | CN | 111712586 | A | |
| | | | | TW | 201937992 | A | |
| | | | | TW | 201934790 | A | |
| | | | | KR | 10-2020-0106529 | A | |
| | | | | CN | 111699274 | A | |
| WO | 2021/131268 | A1 | 01 July 2021 | TW | 202128930 | A | |

Form PCT/ISA/210 (patent family annex) (January 2015)

**EP 4 333 567 A1**

REFERENCES CITED IN THE DESCRIPTION

**Patent documents cited in the description**

- JP 2008266533 A